# EUROPEAN PATENT SPECIFICATION

(11) **EP 3 618 286 B1**
(45) Date of publication and mention of the grant of the patent: **11.11.2026**
(21) Application number: 19193433.0
(22) Date of filing: 23.08.2019
(51) Int. Cl.: H03M 3/00, H04B 1/00, H04B 1/18

(54) **RADIO FREQUENCY BANDPASS DELTA-SIGMA ANALOG-TO-DIGITAL CONVERTERS AND RELATED METHODS**
HOCHFREQUENZ DELTA-SIGMA ANALOG-DIGITAL-WANDLER MIT BANDPASSFILTER, UND DIESBEZÜGLICHE VERFAHREN
CONVERTISSEURS ANALOGIQUE-NUMÉRIQUE DELTA-SIGMA PASSE-BANDE POUR FRÉQUENCE RADIO, ET PROCÉDÉS ASSOCIÉS

(30) Priority: 29.08.2018 US 201862724095 P; 06.08.2019 US 201916533497
(43) Date of publication of application: 04.03.2020
(73) Proprietor: MediaTek Singapore Pte. Ltd., Singapore 138628 (SG)
(72) Inventor: MITTEREGGER, Gerhard, Auburndale, MA Massachusetts 02466 (US)
(74) Representative: Hoefer & Partner Patentanwälte mbB

(56) References cited:
- EP-A1- 3 261 258
- EP-A1- 3 301 813
- US-A- 5 621 345
- US-A1- 2008 025 437
- US-B1- 8 687 739
- SUBHANSHU GUPTA ET AL: "A 0.8 2 GHz Fully-Integrated QPLL-Timed Direct-RF-Sampling Bandpass $\Sigma \Delta$ ADC in 0.13 $\mu$ m CMOS", IEEE JOURNAL OF SOLID-STATE CIRCUITS, IEEE, USA, vol. 47, no. 5, 1 May 2012 (2012-05-01), pages 1141 - 1153, XP011441903, ISSN: 0018-9200, DOI: 10.1109/JSSC.2012.2185530
- PHILIP M CHOPP ET AL: "A 1V 13mW frequency-translating ADC with 55dB SNDR for a 4MHz band at 225MHz", CUSTOM INTEGRATED CIRCUITS CONFERENCE (CICC), 2011 IEEE, IEEE, 19 September 2011 (2011-09-19), pages 1 - 4, XP032063841, ISBN: 978-1-4577-0222-8, DOI: 10.1109/CICC.2011.6055393
- LUSCHAS S ET AL: "RADIO FREQUENCY DIGITAL-TO-ANALOG CONVERTER", IEEE JOURNAL OF SOLID-STATE CIRCUITS, IEEE, USA, vol. 39, no. 9, 1 September 2004 (2004-09-01), pages 1462 - 1467, XP001224134, ISSN: 0018-9200, DOI: 10.1109/JSSC.2004.829377
- MOHAMED BECHIR DADI ET AL: "On the RF subsampling continuous-time [Sigma][Delta] downconversion stage for multistandard receivers", COMPUTER ENGINEERING AND TECHNOLOGY (ICCET), 2010 2ND INTERNATIONAL CONFERENCE ON, IEEE, PISCATAWAY, NJ, USA, 16 April 2010 (2010-04-16), pages V6 - 167, XP031690549, ISBN: 978-1-4244-6347-3
- FRIIS H T: "Noise Figures of Radio Receivers", 31 July 1944 (1944-07-31), Proceedings of the IRE ( Volume: 32, Issue: 7, July 1944), pages 419 - 422, XP093276049, Retrieved from the Internet <URL:https://ieeexplore.ieee.org/stamp/stamp.jsp?tp=&arnumber=1695024> DOI: 10.1109/JRPROC.1944.232049
- ANONYMOUS: "Friis formulas for noise - Wikipedia", 20 January 2018 (2018-01-20), pages 1 - 2, XP093276050, Retrieved from the Internet <URL:https://en.wikipedia.org/w/index.php?title=Friis_formulas_for_noise&oldid=821487487>
- DATABASE COMPENDEX [online] ENGINEERING INFORMATION, INC., NEW YORK, NY, US; 2008, RICHARDS J A: "Radio wave propagation: An introduction for the non-specialist", Database accession no. E20172603854672
- RICHARDS J A: "Radio wave propagation: An introduction for the non-specialist", RADIO WAVE PROPAGATION: AN INTRODUCTION FOR THE NON-SPECIALIST 2008 SPRINGER BERLIN HEIDELBERG, 2008, pages 1 - 127, DOI: 10.1007/978-3-540-77125-8

## Description

### TECHNICAL FIELD

The present application relates to delta-sigma analog-to-digital converters.

### BACKGROUND

Delta-sigma analog-to-digital converters (ADC) use integrators, resonators and feedback loops to filter noise in the low frequencies, so as to enhance signal-to-noise ratio. Some delta-sigma ADCs include digital-to-analog converters (DAC) in the feedback loop.

EP 3 261 258 A1 discloses a sigma-delta modulator for converting an analog input signal having a frequency bandwidth around a variable center frequency to a digital output signal at a sampling frequency. The sigma-delta modulator comprises a quantizer for generating the digital output signal and a loop filter for shaping the quantization noise.

US 8 687 739 B1 discloses a quadrature bandpass-sampling delta-sigma analog-to-digital receiver. The receiver bandpass-samples and quantizes a radio-frequency signal to provide an in-phase bi-level digital signal based on an in-phase clock and a quadrature bi-level digital signal based on a quadrature clock. The in-phase clock frequency and the quadrature clock frequency are equal to the radio-frequency signal carrier frequency. The quadrature clock is ninety degree out of phase with respect to the in-phase clock.

US 2008/025437 A1 discloses a quadrature bandpass-sampling analog-to-digital demodulator. A radio-frequency signal is received by a junction summer, which subtracts an in-phase feedback signal and a quadrature feedback signal from the radio-frequency signal to produce an error signal. The error signal is then bandpassed and amplified by the radio-frequency bandpass filter/amplifier. The amplified signal is bandpass-sampled by two low-resolution analog-to-digital converters clocking in quadrature, and is demodulated and converted into a digital in-phase signal and a digital quadrature signal. The down converted in-phase and quadrature signals are multiplied with two quadrature clocks. The results are converted to two analog signals and fed back to the radio-frequency input at the junction summer.

US 5 621 345 A discloses a circuit that provides samples of in-phase and quadrature components of an input waveform includes an oversampling ADC that receives the input waveform and converts the input waveform to digital samples at an oversampling rate. A first digital filter, coupled to the ADC, receives the digital samples from the ADC and provides the in-phase component. A second digital filter, coupled to the ADC, receives the digital samples from the ADC and provides the quadrature component samples of the input waveform.

S. Gupta et al., "A 0.8-2 GHz Fully-Integrated QPLL-Timed Direct-RF-Sampling Bandpass ΣΔ ADC in 0.13 µm CMOS", IEEE Journal of solid-state circuits 47, 1141 (2012) discloses a reconfigurable bandpass continuous-time ΣΔ ADC tunable over 0.8-2 GHz frequency range.

P.M. Chopp and A.A. Hamoui, "A 1V 13mW Frequency-Translating ΣΔ ADC with 55dB SNDR for a 4MHZ Band at 225MHz", IEEE Journal of Solid-State Circuits 48, 473 (2013) discloses a frequency-translating ΔΣ modulator fabricated in 1V 65nm CMOS for use in digital-IF receivers. Its bandpass ΔΣ architecture uses single-path mixing inside the ΔΣ loop to downconvert a 4MHz input band from 225MHz *(IF1)* to 25MHz *(IF2).* It achieves an SNDR of 55dB, while consuming 13mW. This is realized by sampling at a frequency lower than *IF1,* and by noise-shaping primarily at *IF2.*

S. Luschas, R. Schreier, and H.-S. Lee, "Radio Frequency Digital-to-Analog Converter", IEEE Journal of Solid-State Circuits 39, 1462 (2004) discloses the RF DAC concept of using an oscillator at a multiple of the data clock frequency to control the DAC output waveform.

MOHAMED BECHIR DADI ("On the RF subsampling continuous-time [Sigma][Delta] downconversion stage for multistandard receivers", COMPUTER ENGINEERING AND TECHNOLOGY (ICCET), 2010 2ND INTERNATIONAL CONFERENCE ON, IEEE, PISCATAWAY, NJ, USA, 16 April 2010 (2010-04-16), pages V6-167, ISBN:978-1-4244-6347-3) teaches RF subsampling front-end is based on continuous time (CT) bandpass delta-sigma modulator with sine-shaped feedback DAC, but is silent regarding the filter details.

EP 3301813 Al teaches a delta-sigma modulator, but is silent regarding the DAC types of the filter.

### BRIEF SUMMARY

According to a first aspect of the invention there is provided a method for processing a radio-frequency (RF) signal according to claim 1.
According to a second aspect of the invention there is provided a radio-frequency (RF) receiver according to claim 5.
Optional features are specified in the dependent claims.

### BRIEF DESCRIPTION OF THE DRAWINGS

The accompanying drawings are not intended to be drawn to scale. In the drawings, each identical or nearly identical component that is illustrated in various figures is represented by a like numeral. For purposes of clarity, not every component may be labelled in every drawing.
FIG. 1 is a block diagram illustrating a radio-frequency (RF) receiver including baseband ADCs.
FIG. 2 is a block diagram illustrating a radio-frequency (RF) receiver including a bandpass ADC, in accordance with some embodiments.
FIG. 3 is a block diagram illustrating a radio-frequency (RF) receiver including a bandpass delta-sigma ADC, in accordance with some embodiments.
FIG. 4 is a plot illustrating an example of a frequency-dependent noise response of the receiver of FIG. 3, in accordance with some embodiments.
FIG. 5 is a block diagram illustrating resonant filters that may be used in connection with the receiver of FIG. 3, in accordance with some embodiments.
FIG. 6 is a circuit diagram illustrating an operational amplifier that may be used in connection with the receiver of FIG. 3, in accordance with some embodiments.

### DETAILED DESCRIPTION

The inventor has recognized and appreciated that there is a need for compact, lowpower, low-noise radio-frequency (RF) receivers based on bandpass analog-to-digital converters (ADCs). Compared to receivers designed to first convert the received RF signal to baseband and then to digitize the baseband signal, receivers that digitize the receiver RF signal in a bandpass fashion (directly in the RF domain), have several advantages. For one, these receivers, owing to the fact that RF domain digitization generally does not involve the use of local oscillators and mixers, are significantly smaller and more power efficient.

RF receivers based on bandpass ADCs exist. However, some of these implementations are too noisy and/or are too power hungry. The bandpass ADC-based RF receivers developed by the inventor are more immune to noise than other implementations, achieving for example image rejection ratios (IRR) in excess of 95dB, and exhibit lower power consumptions. Such bandpass ADC-based RF receivers utilize one or more of the following techniques to enhance noise immunity and reduce power consumption: (1) generation of in-phase (I) and quadrature (Q) paths in the digital domain, (2) n^{th} order resonant bandpass filtering with n>1, and (3) signal sub-sampling in an i^{th} Nyquist zone with i>1.

In some embodiments, the I and Q paths are generated in the digital domain, for example using a digital signal processor. Compared to RF receivers in which the I and Q paths are generated in the analog domain, these RF receivers exhibit higher IRRs. This is because analog in-phase and quadrature paths are susceptible to in-phase/quadrature (IQ) mismatch, whereby one of more properties (e.g., gain, frequency, time delay, clock phase and clock magnitude) of the analog I path differs from those of the analog Q path due to fabrication tolerances and process-voltage-temperature variations (PVT).

In some embodiments, the IRR may be further enhanced by using an n^{th} order resonant bandpass filter with n>1. These types of filters significantly attenuate image tones, unwanted tones that are inevitably generated in the RF receiver.

In some embodiments, the received RF signal is sub-sampled in an i^{th} Nyquist zone with i>1. Sub-sampling RF signals in this manner leads to a significant reduction in power consumption and on-chip space usage because it relaxes the frequency with which the signal is sampled.

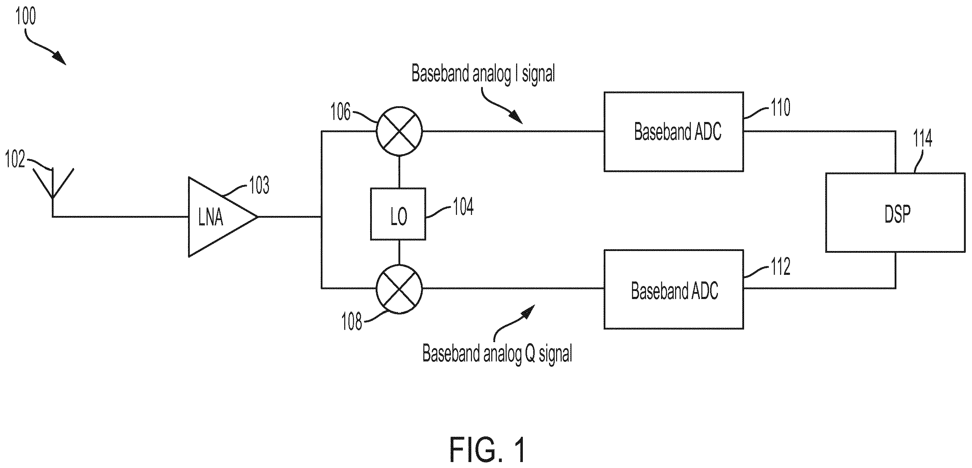

RF receivers of the types described herein are designed to sample the received RF signal in the RF domain without first converting the RF signal to baseband. As such, in some embodiments, these RF receivers may lack local oscillators and/or may lack mixers. For comparison, FIG. 1 illustrates a baseband ADC-based RF receiver including a local oscillator and a pair of mixers. RF receiver 100 includes an antenna 102, a low noise amplifier (LNA) 103, a local oscillator (LO) 104, mixers 106 and 108, baseband ADCs 110 and 112 and digital signal processor (DSP) 114. As shown, the received signal is mixed, using mixers 106 and 108, to a tone provided by LO 104 to generate a baseband analog I signal and a baseband analog Q signal. The baseband analog I signal is digitized using baseband ADC 110 and the baseband analog Q signal is digitized using baseband ADC 112. The outputs of the ADCs are further processed using DSP 114.

Due to fabrication tolerances or process-voltage-temperature variations (PVT), one or more properties of the path over which the baseband analog I signal propagates may differ from that of the path over which the baseband analog Q signal propagates. This behavior leads to a deterioration of the IRR.

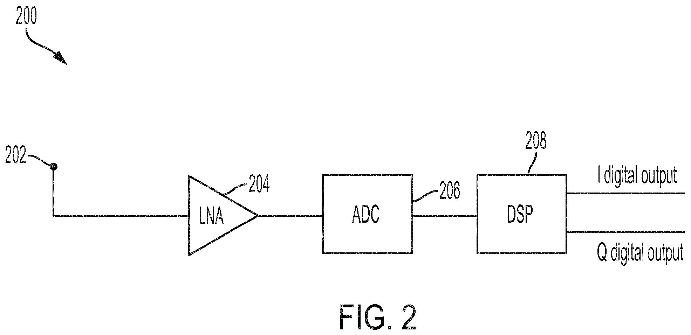

By contrast, the RF receiver of FIG. 2 is designed to sample receiver RF signals in the RF domain, and to generate I and Q signals digitally. RF receiver 200 includes a receive node 202, LNA 204, ADC 206 and DSP 208. Receive node 202 may include an antenna, for example if the communication link is wireless, or other types of conductive terminals, for example if the communication link is wired. Being designed to digitize in the RF domain, in some embodiments, RF receiver 200 may lack local oscillators and/or mixers, though other embodiments may include local oscillators and/or mixers.

As will be described in detail further below, ADC 206 may be implemented as a delta-sigma ADC in some embodiments. As such, ADC 206 may be configured to shape the noise transfer function so that the noise power density at low frequencies is lower than the noise power density at higher frequencies. ADC 206 may be designed so that the signal being received falls in a frequency band in which the noise power density is lower. ADC 206 may include one or more low-pass filters or one or more bandpass filters for shaping the noise transfer function as desired.

In some embodiments, LNA 204 may be directly connected (with no components therebetween other than a conductive path) to ADC 206. Having a direct connection may enhance the signal-to-noise ratio of the RF signal being digitized. However, not all embodiments need to have a direct connection between LNA 204 and ADC 206.

As shown in FIG. 2, I and Q signals are generated in the digital domain, downstream from ADC 206. In this way, IQ mismatch that may otherwise arise when I and Q signals are generated in the analog domain (as in FIG. 1) is prevented. In some embodiments, ADC 206 may be configured to provide n^{th} order resonant bandpass filtering (with n>1) and to sub-sample the received signal in an i^{th} Nyquist zone with i>1.

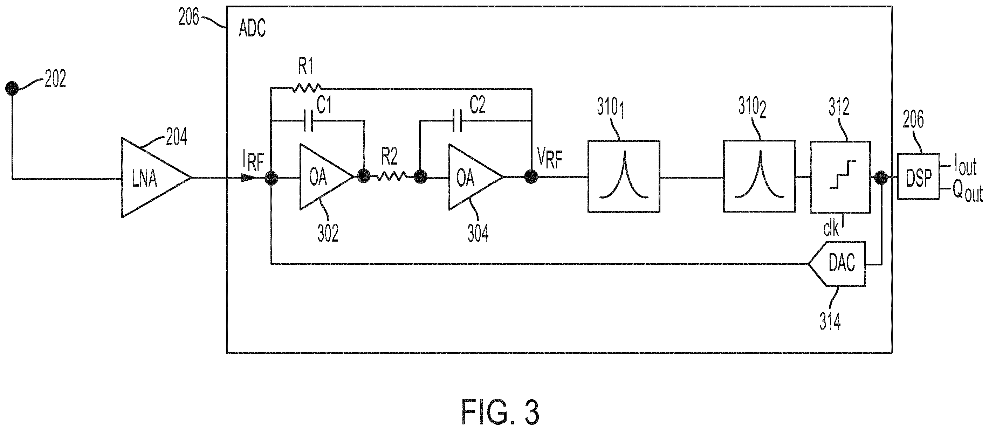

FIG. 3 illustrates one non-limiting implementation of ADC 206, in accordance with some embodiments. In this implementation, ADC 206 includes operational amplifiers (OA) 302 and 304, resistors R1 and R2, capacitors C1 and C2, bandpass resonant filters 310₁ and 310₂, quantizer 312 and DAC 314. It should be appreciated that LNA 204 may be configured as a voltage amplifier and/or a current amplifier. In the example of FIG. 3, LNA 204 is configured to output an amplified current I_{RF} that is representative of the signal received at receive node 202.

In some embodiments, the operational amplifiers, the resistors and the capacitors may be collectively configured as a transimpedance amplifier, thereby converting the current I_{RF} to a voltage V_{RF} at the output of OA 304. In the example of FIG. 3, the transimpedance amplification is provided by the presence of resistor R1 being connected between the input of OA 302 and the output of OA 304. Furthermore, in some embodiments, the operational amplifiers, the resistors and the capacitors may be collectively configured as a lowpass or a bandpass filter (e.g., a bandpass resonant filter).In one example, OA 302 forms an integrator with capacitor C1 and resistor R1, and OA 304 forms an integrator with capacitor C2 and resistor R2. Because the integrators are connected in series, the feedback provided by resistor R1 is a negative feedback. The first integrator provides a 90 degree phase shift at the frequency at which the gain is equal to 1. With two integrators in series, the gain remains equal to one at such frequency and the total phase shift is 180 degrees, leading the integrators to behave as resonators. It should be noted that the circuit exhibits a resonance only at the frequency at which the gain is unitary.

In some embodiments including bandpass resonant filters, the quality factor of the filter may be adjustable, for example by using one or more controllable resistors.

It should be appreciated that arrangements other than that of FIG. 3 may be used in other embodiments. Other embodiments, for example, may include one operational amplifier or more than two operational amplifiers, and/or may include resistors and capacitors arranged in different ways.

In some embodiments, ADC 206 may include an n^{th} order resonant bandpass filter with n>1. The inventor has appreciated that implementing resonant filters with orders greater than 1 may substantially enhance the IRR of the ADC. N^{th} order resonant bandpass filters may be implemented in any suitable way, including using multiple bandpass resonant filters in series with each other. In FIG. 3, for example, ADC 206 includes bandpass resonant filter 310₁ in series with bandpass resonant filter 310₂. It should be appreciated that ADC 206 is not limited to including two bandpass resonant filters 310, as one or more than two filters may be used. Example implementations of such filters are described in detail further below.

In some embodiments, the first filter of the ADC (the filter that is closets to the LNA in the data path from the LNA to the DSP) may have a greater dynamic range than that of the subsequent filters. The dynamic range of the subsequent filters may be relaxed, relative to the first filter, because the loop gain of the ADC reduces noise and other impairments of the subsequent stages. In essence, the gain of the first resonator attenuates the noise of the subsequent stages. This, in turn, simplifies the design of filters 310₁ and 310₂.

Quantizer 312 maps the received RF signal to a set of predefined discrete values. The frequency at which the quantizer 312 samples the received RF signal may be dictated by the frequency of clock clk. In some embodiments, the frequency fₛ of clock clk may be selected so as to sample the received analog signal in an i^{th} Nyquist zone, where i>1. As such, ADC 206 may be configured to sub-sample RF signals. For example, the sampling frequency fₛ may be less than f_{RF}, where f_{RF} is the frequency of the RF signal received at receive node 202. Sub-sampling the received RF signal reduces the overall power consumption of ADC 206.

DSP 206 receives the output of ADC 206 and, in response, it produces an I output (Iₒᵤₜ) and a Q output (Qₒᵤₜ). Iₒᵤₜ and Qₒᵤₜ may be out-of-phase relative to each another by π/2, or more generally, by ±nπ/2 where n is an odd integer. Because the I and Q outputs are generated digitally, in some embodiments, ADC 206 may include a single data path, as opposed to a pair of data paths in quadrature to each other.

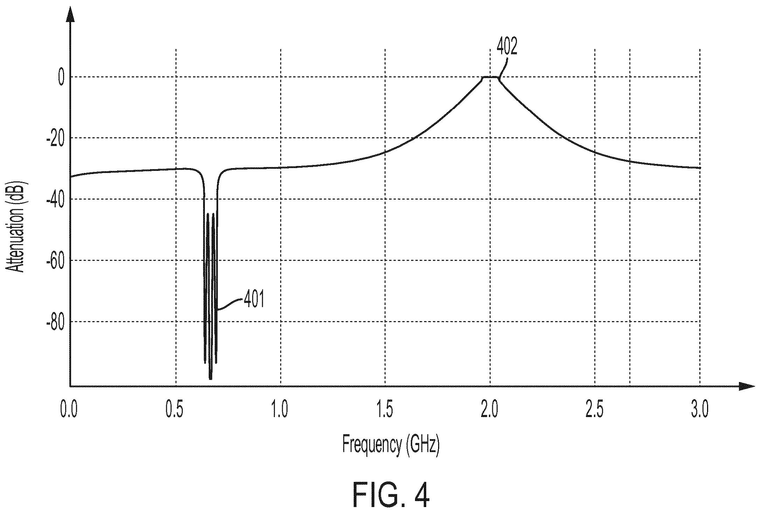

FIG. 4 illustrates an example frequency-dependent noise attenuation response of ADC 206, in accordance with some embodiments. In this example, the received RF signal is assumed to have a carrier frequency equal to approximately 2GHz, though other values are also possible, including for example any value equal to or greater than 1GHz.

In FIG. 4, the response exhibits a quantization noise stop band (and input signal stop band) 401 and a quantization noise stop band (and input signal pass band) 402. It should be noted that the quantization noise stop band 401 exhibits a sharp response with a large roll-off thanks to the use of an n^{th} resonant bandpass filter, as described above. The quantization noise stop band 401 exhibits a dip with a -95dB noise attenuation. In some embodiments, ADC 206 is designed so that the image tone falls within the quantization noise stop band 401. In such embodiments, ADC 206 may exhibit an IRR of 95dB.

DAC 314 may be configured as a mixer DAC. As such DAC 314 may receive a signal having a certain frequency and may output a signal having a higher frequency. The up-conversion may be performed by mixing the signal being provided to the DAC with a reference signal. For example, in some embodiments, DAC 314 may up-convert the frequency output by quantizer 312 from a value between 2GHz and 4GHz to a value between 6GHz and 12GHz.

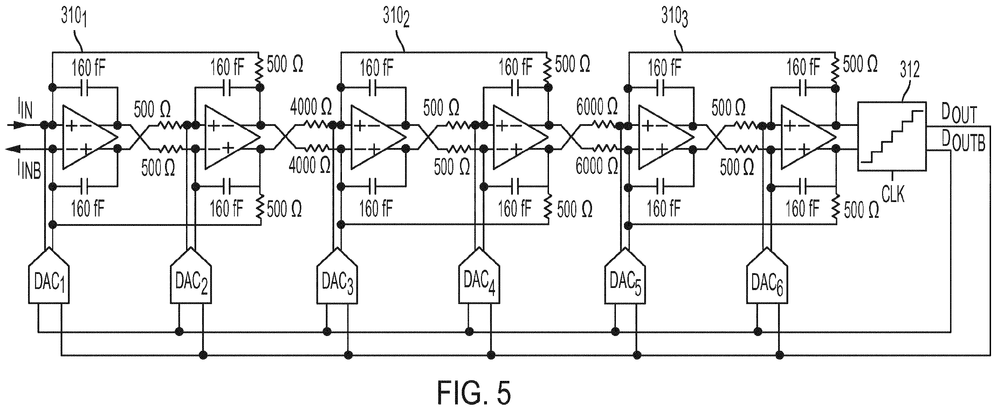

FIG. 5 illustrates one non-limiting implementation of the resonant filters 310, in accordance with some embodiments. In this case, three resonant filters 310₁, 310₂ and 310₃ are shown. Each filter includes a pair of operational amplifiers, 500Ω-resistors and 160fF-capacitors, though other resistances and capacitances are also possible. The filters are coupled to each other by pairs of resistors of increasing resistance. For example, filter 310₁ is coupled to filter 310₂ by a pair of 4000Ω-resistors while filter 310₂ is coupled to filter 310₃ by a pair of 6000Ω-resistors.

Each filter includes an inner feedback loop and an outer feedback loop. Each feedback loop includes a DAC coupled to the output of quantizer 312. DAC₁, DAC₃ and DAC₅ are part of the outer feedback loops of filters 310₁, 310₂ and 310₃, respectively, and are connected to the inputs of such filters. DAC₂, DAC₄ and DAC₆ are part of the inner feedback loops of filters 310₁, 310₂ and 310₃, respectively, and are connected to the respective second operational amplifiers of such filters.

In some embodiments, DAC₁ and DAC₂ may be designed as tri-level DACs and DAC₃, DAC₄, DAC₅ and DAC₆ may be designed as dual-level DACs. When the received digital signal is decoded into a dual-level format, the DAC may be configured to, triggered by an edge of the clock signal, steer current either from the positive output node to the negative output node or from the negative output node to the positive output node. By contrast, when the received digital signal is decoded into a tri-level format, the DAC may be configured to, triggered by an edge of the clock signal, steer current to the positive output node or the negative output node, or dump current to a floating node. When the received digital signal is decoded into a tri-level format, additional output switches may be configured to dump current to a floating node, which reduces noise.

In some embodiments, any one of the operational amplifiers described above, including OA 302, OA 304 and the operational amplifiers of FIG. 5, may be implemented using a multi-path operational amplifier. In some embodiments, the high gain provided by multi-path operational amplifiers leads to high resonator quality factors. Additionally, or alternatively, the high gain provided by multi-path operational amplifiers provides good virtual ground for the high sample rate DACs.

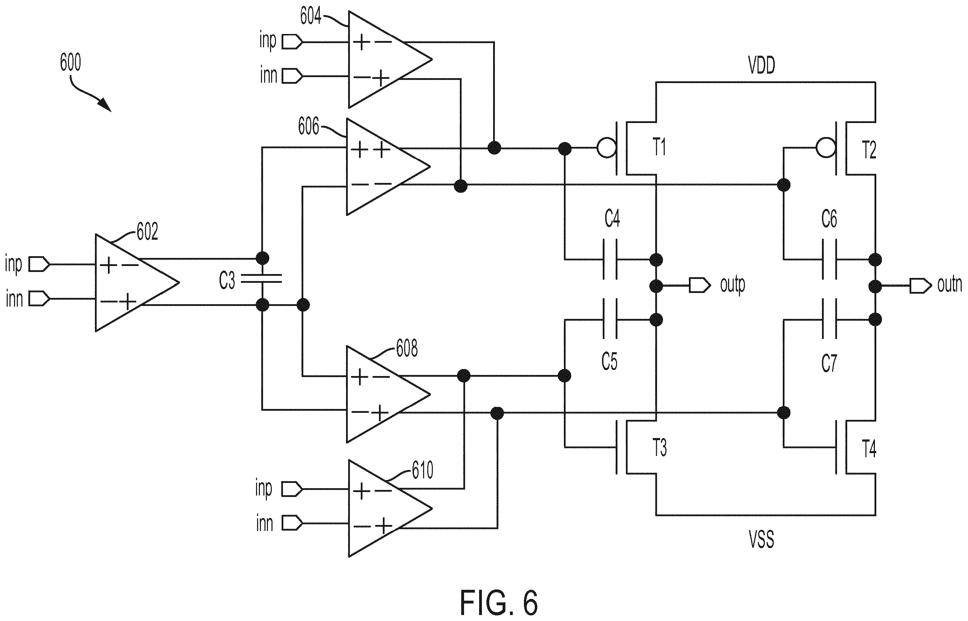

An example of a multi-path operational amplifier is shown in FIG. 6. Multi-path operational amplifier 600 forms a first path with differential operational amplifiers 602, 604 and 606 and a second path with differential operational amplifiers 602, 608 and 610. Multi-path operational amplifier 600 includes an output stage with transistors T1, T2 T3 and T4. Each pair of transistors (a first pair including T1 and T3 and a second pair including T2 and T4) may be arranged as an inverter. Capacitors C3, *C4,* C5, C6 and C7 may have any suitable capacitance.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. The use of "including", "comprising", "having", "containing" or "involving" and variations thereof herein, is meant to encompass the items listed thereafter and equivalents thereof as well as additional items.

The use of "coupled" or "connected" is meant to refer to circuit elements, or signals, that are either directly linked to one another or through intermediate components.

The terms "approximately", "substantially," and "about" may be used to mean within ±20% of a target value in some embodiments, within ±10% of a target value in some embodiments, within ±5% of a target value in some embodiments, and within ±2% of a target value in some embodiments. The terms "approximately" and "about" may include the target value.

## Claims

1. A method for processing a radio-frequency, RF, signal, the method comprising; amplifying (204) the RF signal;
digitizing, with a delta-sigma analog-to-digital converter, ADC, the amplified RF signal in an RF domain, wherein the digitizing comprises:
filtering (310) the amplified RF signal with an n^{th} order resonant bandpass filter, where n>1, comprising filtering the amplified RF signal with a first filter (310₁) and one or more subsequent filters (310₂, 310₃) downstream from the first filter, wherein the first filter has a greater dynamic range than the one or more subsequent filters; and
sampling, by a quantizer (312), the filtered RF signal in an i^{th} Nyquist zone, where i>1; and
producing (208) based on an output of the delta-sigma ADC an in-phase (I) signal and a quadrature (O) signal digitally;
wherein each of the first filter and the one or more subsequent filter comprises at least a first operational amplifier, a second operational amplifier, a first digital to analog converter, DAC, (DAC₁, DAC₃, DAC₅) and a second DAC (DAC₂, DAC₄, DAC₆), wherein the second operational amplifier is serially coupled after the first operational amplifier, the first DAC is coupled between the input of the first operational amplifier and an output of the quantizer, and the second DAC is coupled between the input of the second operational amplifier and the output of the quantizer, wherein the first DAC (DAC₁) and the second DAC (DAC₂) of the first filter are designed as tri-level DACs, and wherein the first DACs (DAC₃, DAC₅) and the second DACs (DAC₄, DAC₆) of the one or more subsequent filters are designed as dual-level DACs.

2. The method of claim 1, wherein converting the output of the quantizer with the first DAC comprises up-converting a frequency of the output of the quantizer.

3. The method of claim 2, wherein up-converting the frequency of the output of the quantizer comprises up-converting the frequency from 2-4GHz to 6-12GHz.

4. The method of any preceding claim, wherein amplifying the RF signal comprises amplifying the RF signal with a low noise amplifier directly connected to the ADC.

5. A radio-frequency, RF, receiver comprising:
a low noise amplifier, LNA, (204) configured to receive an RF signal and generate an amplified RF signal; and
an RF domain delta-sigma analog-to-digital converter, ADC, (206) configured to receive the amplified RF signal, the RF domain delta-sigma ADC comprising:
an n^{th} order resonant bandpass filter (310) configured to receive the amplified RF signal and generate a filtered RF signal, where n>1, comprising a first filter (310₁) and one or more subsequent filters (310₂, 310₃) downstream from the first filter, wherein the first filter has a greater dynamic range than the one or more subsequent filters; and
a quantizer (312) configured to sample the filtered RF signal in an i^{th} Nyquist zone, where i>1; and
circuitry configured to receive an output of the RF domain delta-sigma ADC and produce an in-phase (I) signal and a quadrature (Q) signal digitally;
wherein each of the first filter and the one or more subsequent filter comprises at least a first operational amplifier, a second operational amplifier, a first digital to analog converter, DAC, (DAC₁, DAC₃, DAC₅) and a second DAC (DAC₂, DAC₄, DAC₆), wherein the second operational amplifier is serially coupled after the first operational amplifier, the first DAC is coupled between the input of the first operational amplifier and an output of the quantizer, and the second DAC is coupled between the input of the second operational amplifier and the output of the quantizer, wherein the first DAC (DAC₁) and the second DAC (DAC₂) of the first filter are designed as tri-level DACs, and wherein the first DACs (DAC₃, DAC₅) and the second DACs (DAC₄, DAC₆) of the one or more subsequent filters are designed as dual-level DACs.

6. The RF receiver of claim 5, wherein the first DAC is configured to up-convert a frequency of the output of the quantizer.

7. The RF receiver of claim 6, wherein the first DAC is configured to up-convert the frequency from 2-4GHz to 6-12GHz.

8. The RF receiver of any of claims 5-7, wherein the LNA is directly connected the ADC.

9. The RF receiver of any of claims 5-8, wherein the RF receiver lacks local oscillators.

## Patentansprüche

1. Verfahren zum Verarbeiten eines Funkfrequenz-, RF-, Signals, wobei das Verfahren umfasst:
Verstärken (204) des RF-Signals;
Digitalisieren, mit einem Delta-Sigma- Analog-Digital-Wandler, ADC, des verstärkten RF-Signals in einer RF-Domäne, wobei das Digitalisieren umfasst:
Filtern (310) des verstärkten RF-Signals mit einem resonanten Bandpassfilter n-ter Ordnung, wobei n>1, umfassend Filtern des verstärkten RF-Signals mit einem ersten Filter (310₁) und einem oder mehreren dem ersten Filter nachgeschalteten nachfolgenden Filtern (310₂, 310₃), wobei der erste Filter einen größeren Dynamikbereich als der eine oder die mehreren nachfolgenden Filter aufweist; und
Abtasten, durch einen Quantisierer (312), des gefilterten RF-Signals in einer i-ten Nyquist-Zone, wobei i>1; und
Erzeugen (208), basierend auf einer Ausgabe des Delta-Sigma-ADC, eines In-Phase-(I-) Signals und eines Quadratur- (O-) Signals digital;
wobei jeder des ersten Filters und des einen oder der mehreren nachfolgenden Filter mindestens einen ersten Operationsverstärker, einen zweiten Operationsverstärker, einen ersten Digital-Analog-Wandler, DAC, (DAC₁, DAC₃, DAC₅) und einen zweiten DAC (DAC₂, DAC₄, DAC₆) umfasst, wobei der zweite Operationsverstärker seriell nach dem ersten Operationsverstärker gekoppelt ist, der erste DAC zwischen den Eingang des ersten Operationsverstärkers und einen Ausgang des Quantisierers gekoppelt ist und der zweite DAC zwischen den Eingang des zweiten Operationsverstärkers und den Ausgang des Quantisierers gekoppelt ist, wobei der erste DAC (DAC₁) und der zweite DAC (DAC₂) des ersten Filters als Drei-Pegel-DACs ausgelegt sind und wobei die ersten DACs (DAC₃, DAC₅) und die zweiten DACs (DAC₄, DAC₆) des einen oder der mehreren nachfolgenden Filter als Dual-Pegel-DACs ausgelegt sind.

2. Verfahren nach Anspruch 1, wobei Umwandeln der Ausgabe des Quantisierers mit dem ersten DAC Aufwärtswandeln einer Frequenz der Ausgabe des Quantisierers umfasst.

3. Verfahren nach Anspruch 2, wobei Aufwärtswandeln der Frequenz der Ausgabe des Quantisierers Aufwärtswandeln der Frequenz von 2-4 GHz auf 6-12 GHz umfasst.

4. Verfahren nach einem der vorhergehenden Ansprüche, wobei Verstärken des RF-Signals Verstärken des RF-Signals mit einem rauscharmen Verstärker umfasst, der direkt mit dem ADC verbunden ist.

5. Funkfrequenz-, RF-, Empfänger, umfassend:
einen rauscharmen Verstärker, LNA, (204), der konfiguriert ist, um ein RF-Signal zu empfangen und ein verstärktes RF-Signal zu erzeugen; und
einen RF-Domänen-Delta-Sigma- Analog-Digital-Wandler, ADC, (206), der konfiguriert ist, um das verstärkte RF-Signal zu empfangen, wobei der RF-Domänen-Delta-Sigma-ADC umfasst:
einen resonanten Bandpassfilter n-ter Ordnung (310), der konfiguriert ist, um das verstärkte RF-Signal zu empfangen und ein gefiltertes RF-Signal zu erzeugen, wobei n>1, umfassend einen ersten Filter (310₁) und einen oder mehrere dem ersten Filter nachgeschaltete nachfolgende Filter (310₂, 310₃), wobei der erste Filter einen größeren Dynamikbereich als der eine oder die mehreren nachfolgenden Filter aufweist; und
einen Quantisierer (312), der konfiguriert ist, um das gefilterte RF-Signal in einer i-ten Nyquist-Zone abzutasten, wobei i>1; und
Schaltungen, die konfiguriert sind, um eine Ausgabe des RF-Domänen-Delta-Sigma-ADC zu empfangen und ein In-Phase- (I-) Signal und ein Quadratur- (Q-) Signal digital zu erzeugen;
wobei jeder des ersten Filters und des einen oder der mehreren nachfolgenden Filter mindestens einen ersten Operationsverstärker, einen zweiten Operationsverstärker, einen ersten Digital-Analog-Wandler, DAC, (DAC₁, DAC₃, DAC₅) und einen zweiten DAC (DAC₂, DAC₄, DAC₆) umfasst, wobei der zweite Operationsverstärker seriell nach dem ersten Operationsverstärker gekoppelt ist, der erste DAC zwischen den Eingang des ersten Operationsverstärkers und einen Ausgang des Quantisierers gekoppelt ist und der zweite DAC zwischen den Eingang des zweiten Operationsverstärkers und den Ausgang des Quantisierers gekoppelt ist, wobei der erste DAC (DAC₁) und der zweite DAC (DAC₂) des ersten Filters als Drei-Pegel-DACs ausgelegt sind und wobei die ersten DACs (DAC₃, DAC₅) und die zweiten DACs (DAC₄, DAC₆) des einen oder der mehreren nachfolgenden Filter als Dual-Pegel-DACs ausgelegt sind.

6. RF-Empfänger nach Anspruch 5, wobei der erste DAC konfiguriert ist, um eine Frequenz der Ausgabe des Quantisierers aufwärtszuwandeln.

7. RF-Empfänger nach Anspruch 6, wobei der erste DAC konfiguriert ist, um die Frequenz von 2-4 GHz auf 6-12 GHz aufwärtszuwandeln.

8. RF-Empfänger nach einem der Ansprüche 5-7, wobei der LNA direkt mit dem ADC verbunden ist.

9. RF-Empfänger nach einem der Ansprüche 5-8, wobei der RF-Empfänger keine lokalen Oszillatoren aufweist.

## Revendications

1. Procédé de traitement d'un signal radiofréquence, RF, le procédé comprenant :
l'amplification (204) du signal RF ;
la numérisation, avec un convertisseur analogique-numérique, ADC, delta-sigma, du signal RF amplifié dans un domaine RF, dans lequel la numérisation comprend :
le filtrage (310) du signal RF amplifié avec un filtre passe-bande résonant d'ordre n, où n > 1, comprenant le filtrage du signal RF amplifié avec un premier filtre (310₁) et un ou plusieurs filtres suivants (310₂, 310₃) en aval du premier filtre, dans lequel le premier filtre a une plage dynamique plus grande que les un ou plusieurs filtres suivants ; et
l'échantillonnage, par un quantificateur (312), du signal RF filtré dans une ième zone de Nyquist, où i > 1 ; et
la production (208) sur la base d'une sortie de l'ADC delta-sigma d'un signal en phase (I) et d'un signal en quadrature (O) numériquement ;
dans lequel chacun du premier filtre et des un ou plusieurs filtres suivants comprend au moins un premier amplificateur opérationnel, un second amplificateur opérationnel, un premier convertisseur numérique-analogique, DAC, (DAC₁, DAC₃, DAC₅) et un second DAC (DAC₂, DAC₄, DAC₆), dans lequel le second amplificateur opérationnel est couplé en série après le premier amplificateur opérationnel, le premier DAC est couplé entre l'entrée du premier amplificateur opérationnel et une sortie du quantificateur, et le second DAC est couplé entre l'entrée du second amplificateur opérationnel et la sortie du quantificateur, dans lequel le premier DAC (DAC₁) et le second DAC (DAC₂) du premier filtre sont conçus comme des DAC à trois niveaux, et dans lequel les premiers DAC (DAC₃, DAC₅) et les seconds DAC (DAC₄, DAC₆) des un ou plusieurs filtres suivants sont conçus comme des DAC à deux niveaux.

2. Procédé selon la revendication 1, dans lequel la conversion de la sortie du quantificateur avec le premier DAC comprend la conversion ascendante d'une fréquence de la sortie du quantificateur.

3. Procédé selon la revendication 2, dans lequel la conversion ascendante de la fréquence de la sortie du quantificateur comprend la conversion ascendante de la fréquence de 2-4 GHz à 6-12 GHz.

4. Procédé selon l'une quelconque des revendications précédentes, dans lequel l'amplification du signal RF comprend l'amplification du signal RF avec un amplificateur à faible bruit directement connecté à l'ADC.

5. Récepteur radiofréquence, RF, comprenant :
un amplificateur à faible bruit, LNA, (204) configuré pour recevoir un signal RF et générer un signal RF amplifié ; et
un convertisseur analogique-numérique, ADC, delta-sigma de domaine RF (206) configuré pour recevoir le signal RF amplifié, l'ADC delta-sigma de domaine RF comprenant :
un filtre passe-bande résonant d'ordre n (310) configuré pour recevoir le signal RF amplifié et générer un signal RF filtré, où n > 1, comprenant un premier filtre (310₁) et un ou plusieurs filtres suivants (310₂, 310₃) en aval du premier filtre, dans lequel le premier filtre a une plage dynamique plus grande que les un ou plusieurs filtres suivants ; et
un quantificateur (312) configuré pour échantillonner le signal RF filtré dans une ième zone de Nyquist, où i > 1 ; et
une circuiterie configurée pour recevoir une sortie de l'ADC delta-sigma de domaine RF et produire un signal en phase (I) et un signal en quadrature (Q) numériquement ;
dans lequel chacun du premier filtre et des un ou plusieurs filtres suivants comprend au moins un premier amplificateur opérationnel, un second amplificateur opérationnel, un premier convertisseur numérique-analogique, DAC, (DAC₁, DAC₃, DAC₅) et un second DAC (DAC₂, DAC₄, DAC₆), dans lequel le second amplificateur opérationnel est couplé en série après le premier amplificateur opérationnel, le premier DAC est couplé entre l'entrée du premier amplificateur opérationnel et une sortie du quantificateur, et le second DAC est couplé entre l'entrée du second amplificateur opérationnel et la sortie du quantificateur, dans lequel le premier DAC (DAC₁) et le second DAC (DAC₂) du premier filtre sont conçus comme des DAC à trois niveaux, et dans lequel les premiers DAC (DAC₃, DAC₅) et les seconds DAC (DAC₄, DAC₆) des un ou plusieurs filtres suivants sont conçus comme des DAC à deux niveaux.

6. Récepteur RF selon la revendication 5, dans lequel le premier DAC est configuré pour convertir ascendante une fréquence de la sortie du quantificateur.

7. Récepteur RF selon la revendication 6, dans lequel le premier DAC est configuré pour convertir ascendante la fréquence de 2-4 GHz à 6-12 GHz.

8. Récepteur RF selon l'une quelconque des revendications 5 à 7, dans lequel le LNA est directement connecté à l'ADC.

9. Récepteur RF selon l'une quelconque des revendications 5 à 8, dans lequel le récepteur RF est dépourvu d'oscillateurs locaux.
